**Europäisches Patentamt**

**European Patent Office**

**Office européen des brevets**

(19)

(11) Veröffentlichungsnummer : **0 073 402
B1**

(12) **EUROPÄISCHE PATENTSCHRIFT**

(45) Veröffentlichungstag der Patentschrift :
**11.12.85**

(51) Int. Cl.⁴ : **G 01 N 24/06**

(21) Anmeldenummer : **82107453.1**

(22) Anmeldetag : **16.08.82**

(54) **Gradientenspulen-System für eine Einrichtung der Kernspinresonanz-Technik.**

(30) Priorität : **27.08.81 DE 3133873**

(43) Veröffentlichungstag der Anmeldung :
**09.03.83 Patentblatt 83/10**

(45) Bekanntmachung des Hinweises auf die Patenterteilung : **11.12.85 Patentblatt 85/50**

(84) Benannte Vertragsstaaten :
**DE FR GB NL**

(56) Entgegenhaltungen :
**DE-A- 2 840 178
US-A- 3 287 630
US-A- 3 566 255
US-A- 3 569 823
JOURNAL OF MAGNETIC RESONANCE Vol. 29, 1978,
P. MANSFIELD et al. "Biological and Medical Imaging
by NMR" Seiten 355 bis 373**

(73) Patentinhaber : **Siemens Aktiengesellschaft
Berlin und München Wittelsbacherplatz 2
D-8000 München 2 (DE)**

(72) Erfinder : **Frese, Georg, Dipl.-Phys.
Weiherstrasse 15
D-8520 Erlangen (DE)**
Erfinder : **Siebold, Horst, Dr.
Starenweg 3
D-8520 Erlangen (DE)**

**Beschreibung**

Die Erfindung bezieht sich auf ein Gradientenspulen-System für eine Einrichtung zur Erzeugung von Abbildungen eines Objekts mit Hilfe der Kernspinresonanztechnik, insbesondere für die Zeugmatographie, mit

einem den Radius r aufweisenden hohlzylindrischen Trägerkörper, der einen Abbildungsbereich umschließt und dessen die z-Achse eines rechtwinkligen Koordinatensystems definierende Zylinderachse der Richtung des Grundmagnetfeldes $B_z$ der Einrichtung entspricht,

mindestens einem Paar von ringförmigen Einzelspulen, die zur Erzeugung eines im Abbildungsbereich im wesentlichen konstanten Magnetfeldgradienten $G_z = \partial B_z/\partial z$ entlang der z-Achse auf dem Trägerkörper symmetrisch bezüglich einer durch den Abbildungsbereich senkrecht zur z-Achse verlaufenden und die x-y-Ebene des Koordinatensystems bildenden Querschnittsebene angeordnet und gegensinnig stromdurchflossen sind,

einem ersten der Erzeugung eines im Abbildungsbereich im wesentlichen konstanten Magnetfeldgradienten $G_x = \partial B_z/\partial x$ des Grundmagnetfeldes $B_z$ in x-Richtung dienenden Satz von sattelförmigen Einzelspulen, die sich paarweise gegenüberliegend auf die Mantelfläche des Trägerkörpers aufgesetzt und außerdem paarweise symmetrisch bezüglich der genannten Querschnittsebene angeordnet sind und jeweils zwei in z-Richtung verlaufende gerade Leiterstücke sowie jeweils zwei senkrecht zur z-Achse in Umfangsrichtung des Trägerkörpers verlaufende bogenförmige Leiterstücke aufweisen, wobei die Stromrichtung in den in Umfangsrichtung benachbarten geraden Leiterstücken von sich paarweise gegenüberliegenden sattelförmigen Einzelspulen jeweils gleich und ferner jeweils entgegengesetzt zu der Stromrichtung in den beiden entsprechenden geraden Leiterstücken der jeweils zu diesen Einzelspulen symmetrischen Einzelspulen ist, sowie

einem dem ersten Satz entsprechenden zweiten Satz von sattelförmigen Einzelspulen zur Erzeugung eines im Abbildungsbereich im wesentlichen konstanten Magnetfeldgradienten $G_y = \partial B_z/\partial y$ des Grundmagnetfeldes $B_z$ in y-Richtung.

Ein solches Gradientenspulen-System ist aus der US-A-3 569 823 bekannt.

Auf dem Gebiet der medizinischen Diagnostik sind Abbildungsverfahren vorgeschlagen worden, bei denen durch rechnerische oder meßtechnische Analyse integraler Protonenresonanzsignale aus der räumlichen Spindichte- und/oder Relaxationszeitenverteilung eines zu untersuchenden menschlichen Körpers ein Bild ähnlich einem Röntgentomogramm konstruiert wird. Die entsprechende Methode wird auch als Zeugmatographie bzw. Kernspintomographie bezeichnet (« Nature », Band 242, 1973, Seiten 190 bis 191).

Zur Kernspintomographie nach bekannten Verfahren werden prinzipiell drei verschiedene Arten von Spulensystemen benötigt. Danach ist ein Magnet zur Erzeugung eines möglichst homogenen, stationären Grundfeldes $B_z$ in der Größenordnung von 0,05 bis 0,5 Tesla erforderlich. Dieses Magnetfeld $B_z$ sei z. B. in z-Richtung eines rechtwinkligen x-y-z-Koordinatensystems orientiert, die zugleich die Untersuchungsachse ist, längs derer ein zu untersuchender, insbesondere menschlicher Körper in das Magnetfeld eingebracht wird. Der Koordinatenursprung soll dabei in den Abbildungs- bzw. Untersuchungsbereich gelegt sein. Ferner ist eine Hochfrequenz-Spulenanordnung für die entsprechende Präzessionsfrequenz der zu betrachtenden Kernspins vorzusehen, um die Kernspins anzuregen und gegebenenfalls auch die Induktionssignale empfangen zu können. Falls die Hochfrequenz-Spulenanordnung nicht zur Detektion dieser Signale mitverwendet wird, kann auch ein besonderes Empfangsspulensystem vorgesehen sein. Schließlich wird noch ein System von Gradientenspulen benötigt, die einen vorzugsweise orthogonalen Satz von Zusatzfeldern $G_z = \partial B_z/\partial z$, $G_x = \partial B_z/\partial x$ und $G_y = \partial B_z/\partial y$ erzeugen. Diese Zusatzfelder sind klein gegen das in z-Richtung orientierte Grundfeld $B_z$. Erst die in einer vorbestimmten Reihenfolge eingeschalteten Gradientenfelder erlauben eine Unterscheidung im Ort durch einen Verlauf der Präzessionsfrequenz der Kerne über dem Ort (vgl. z. B. « Journal of Magnetic Resonance », Vol. 18, 1975, Seiten 69 bis 83 oder Vol. 29, 1978, Seiten 355 bis 373).

Sind diese Gradienten $G_x$, $G_y$ und $G_z$ in einem Abbildungsbereich nicht zumindest weitgehend konstant, sondern noch Funktionen vom Ort selbst, so entstehen Bild-Unschärfen, -Verzerrungen und -Artefakte. Die Linearität der Gradientenfelder bzw. die Konstanz ihrer Ableitungen $G_x$, $G_y$, $G_z$ in dem Abbildungsbereich ist deshalb eine wesentliche Voraussetzung für eine gute Bildqualität von Kernspintomographie-Apparaturen.

Allgemein lassen sich die genannten Feldgradienten $G_x$, $G_y$ und $G_z$ durch magnetische Quadrupole erzeugen. Für Einrichtungen der Kernspinresonanz-Technik muß dabei berücksichtigt werden, daß die Spulen zur Erzeugung der Gradienten im Inneren des Grundfeldmagneten angeordnet werden müssen, wobei für die Lagerung des zu untersuchenden, insbesondere menschlichen Körpers genügend Raum offen bleiben muß.

Eine analytische Ableitung der Geometrie entsprechender Spulensysteme ist der eingangs genannten US-A-3 569 823 zu entnehmen. Danach sollen die Spulen jeweils eine Ordnung des in Kugelfunktionen entwickelten Magnetfeldes möglichst rein wiedergeben. Hierbei ist davon ausgegangen, daß ihre felderzeugenden Leiter auf der Außen- und/oder Innenmantelfläche eines hohlzylindrischen Trägerkörpers angeordnet sind. Bei dieser Anordnung sind Störungen der Hauptkugelfunktionen, die durch eine endliche Länge der Leiter und deren Lage entstehen, analytisch minimiert.

Der hohlzylindrische Trägerkörper mit den entsprechenden Gradientenspulen kann in einen Grundfeldmagneten eingeschoben werden, wobei seine Achse auf die Achse des Grundmagneten fällt, welche z. B. in z-Richtung eines rechtwinkligen x-y-z-Koordinatensystems weist. Der z-Gradient $G_z$ wird durch zwei gegensinnig stromdurchflossene Ringspulen erzeugt. Zur Erzeugung des x-Gradienten $G_x$ sind zwei Sattelspulen-Paare auf dem Trägerkörper aufgebracht. Für den y-Gradienten $G_y$ ist ein entsprechendes System von vier Sattelspulen vorgesehen, die gegenüber den x-Gradientenspulen auf dem Außen- oder Innenmantel des zylindrischen Trägerkörpers um 90° in Umfangsrichtung versetzt angeordnet sind. Die beiden Paare von Einzelspulen jedes Spulensatzes sind dabei symmetrisch zu einer senkrecht bezüglich der Zylinderachse ausgerichteten x-y-Ebene, die durch das Zentrum des Abbildungsbereiches verläuft, angeordnet.

Bei der Berechnung dieses Spulensystems ist davon ausgegangen, daß eine gute Linearität des Gradientenfeldes in der radialen x-y-Ebene, die zugleich die Symmetrieebene durch das Zentrum des Abbildungsbereiches darstellt, erreicht wird. Für die Aufnahme von Ganzkörperbildern mit einer Einrichtung der Kernsinresonanz-Technik wird jedoch eine Linearität dieses Feldes nicht nur in einem ebenen, flächenhaften Abbildungsbereich, sondern in einem kugelförmigen Volumen mit einem Radius von beispielsweise 20 cm gefordert. Man möchte nämlich die Bildebene beliebig im Raum orientieren können. Das bedeutet aber, daß auch die Linearität der Gradientenfelder über dieses gesamte Volumen zu fordern ist. Hierbei sollen die Gradienten bis unter beispielsweise 5 % konstant sein, um wesentliche Verzerrungen des Bildes zu vermeiden.

Aufgabe der vorliegenden Erfindung ist es deshalb, das eingangs genannte Gradientenspulen-System so auszugestalten, daß auf verhältnismäßig einfache Weise ein dreidimensional ausgedehnter Abbildungsbereich mit der geforderten Linearität der x- und/oder y-Gradienten erhalten wird.

Zur Lösung dieser Aufgabe ist gemäß der Erfindung vorgesehen,

a) daß den der genannten Querschnittsebene unmittelbar benachbarten bogenförmigen Leiterstücken der sattelförmigen Einzelspulen zur Erzeugung der x- bzw. y-Feldgradienten $G_x$ bzw. $G_y$ jeweils ein weiteres bogenförmiges Leiterstück parallelgeschaltet ist,

b) daß die Abstände der einzelnen bogenförmigen Leiterstücke dieser Einzelspulen von der Querschnittsebene vorbestimmte Werte $a_1$ bzw. $a_3$ bzw. $a_2$ haben, und

c) daß die Amperewindungszahlen dieser bogenförmigen Leiterstücke vorbestimmte, mit zunehmendem Abstand von der Querschnittsebene wachsende Werte haben.

Die mit dieser Gestaltung des Gradientenspulen-Systems verbundenen Vorteile sind insbesondere darin zu sehen, daß für die x- und/oder y-Gradientenspulen mit der erfindungsgemäßen Aufspaltung der der genannten Querschnittsebene zugewandten bogenförmigen Leiterstücke in jeweils zwei Leiterbogen und mit der vorbestimmten, auch als Durchflutung bezeichneten Amperewindungszahl durch diese Leiterbogen ein Linearitätsbereich zu erreichen ist, der auch in z-Richtung eine ausgeprägte Ausdehnung aufweist. Zugleich können die Abmessungen der Einzelspulen klein gehalten werden, um somit den Strombedarf und die Induktivität der Spulen zu begrenzen. Die Gradientenfelder lassen sich dann, wie es für viele bildgebende Einrichtungen erforderlich ist, in kurzen Zeiten ein- und ausschalten.

Vorteilhafte Ausgestaltungen des Gradientenspulen-Systems nach der Erfindung gehen aus den Unteransprüchen hervor.

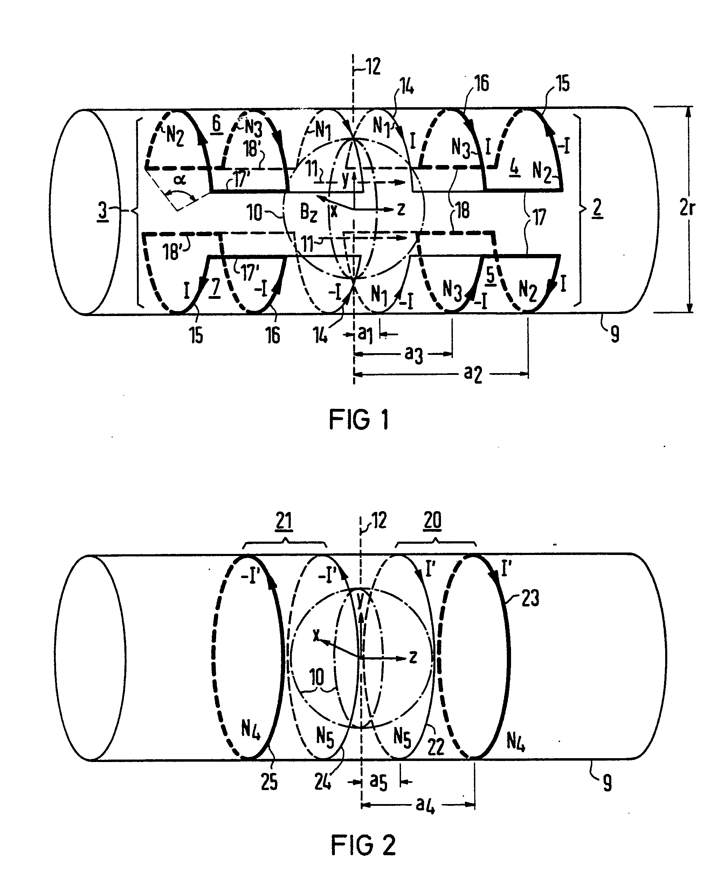

Zur weiteren Erläuterung der Erfindung und deren in den Unteransprüchen gekennzeichneten Weiterbildungen wird auf die Zeichnung Bezug genommen, in deren Fig. 1 die erfindungsgemäß ausgebildeten x- oder y-Gradientenspulen einer bildgebenden Einrichtung der Kernspinresonanz-Technik schematisch dargestellt sind. Fig. 2 zeigt schematisch z-Gradientenspulen einer solchen Einrichtung.

Bei der Einrichtung der Kernspinresonanz-Technik, insbesondere zur Zeugmatographie bzw. Kernspintomographie, für welche das Gradientenspulen-System nach der Erfindung vorgesehen sein soll, wird von bekannten Magnetspulenanordnungen ausgegangen. Eine entsprechende Magnetspulenanordnung ist z. B. in der US-A-3 569 823 angedeutet. Diese Magnetspulenanordnung hat mindestens ein bezüglich der z-Achse eines rechtwinkligen x-y-z-Koordinatensystems konzentrisch angeordnetes normal- oder supraleitendes Feldspulensystem zur Erzeugung eines homogenen magnetischen Grundfeldes in z-Richtung. Ferner sind Gradientenspulen zur Erzeugung hinreichend konstanter magnetischer Feldgradienten in einem Abbildungsbereich vorgesehen, in dessen Zentrum sich der Koordinatenursprung des Koordinatensystems befinden soll. Die Magnetspulenanordnung erlaubt einen axialen Zugang zum homogenen Feldbereich in ihrem Zentrum, d. h. der zu untersuchende, beispielsweise menschliche Körper wird längs der z-Achse in das Magnetfeld eingebracht. Die Anregung des Kernspins erfolgt mittels eines senkrecht zur z-Achse gerichteten Hochfrequenzfeldes von Spulen, die auch als Empfängerspulen zur Aufnahme der Kernspinresonanzsignale dienen können.

Für eine solche Einrichtung der Kernspinresonanz-Technik kann das Gradientenspulen-System nach der Erfindung vorgesehen sein. Dieses Spulensystem umfaßt x- und y-Gradientenspulen, von denen ein Spulensystem, z. B. das System zur Erzeugung der y-Gradienten, in Fig. 1 in Schrägansicht schematisch veranschaulicht ist. Verdeckte Leiterteile sind dabei in der Figur durch gestrichelte Linien angedeutet. Das Spulensystem, mit dem in einem Abbildungsbereich hinreichend lineare Gradientenfelder in x- bzw. y-Richtung erzeugt werden sollen, umfaßt zwei Paare 2 und 3 mit je zwei sattelförmigen Einzelspulen 4 und 5 bzw. 6 und 7. Diese Einzelspulen sind auf der Außen- und/oder Innenmantelfläche eines hohlzylindrischen Trägerkörpers 9 angeordnet, dessen Außen- bzw. Innenradius die Größe r hat und dessen Zylinderachse in z-Richtung eines rechtwinkligen x-y-z-Koordinatensystems weisen soll. Diese Achse ist zugleich die Untersuchungsachse, längs derer ein zu untersuchender, beispielsweise menschlicher Körper in den durch strichpunktierte Linien angedeuteten Untersuchungs- bzw. Abbildungsbereich 10 eingebracht werden kann. In diesem Bereich soll das durch gestrichelte, gepfeilte Linien 11 angedeutete magnetische Feld $B_z$ eines Grundfeldmagneten zumindest weitgehend homogen und in z-Richtung orientiert sein. Der Koordinatenursprung des x-y-z-Koordinantensystems ist in das Zentrum des Abbildungsbereiches gelegt.

Die beiden Spulenpaare 2 und 3 sind bezüglich einer durch das Zentrum des Abbildungsbereiches verlaufenden x-y-Ebene symmetrisch angeordnet. Diese Symmetrieebene ist durch eine gestrichelte Linie 12 angedeutet.

Um eine gemäß den Homogenitätsforderungen für bildgebende Einrichtungen der Kernspinresonanz-Technik ausreichende Linearität der beispielsweise x-Gradientenfelder zu gewährleisten, enthält jede der vier Einzelspulen 4 bis 7 neben einem stirnseitigen, der Symmetrieebene 12 zugewandten bogenförmigen Leiterstück 14 mit einer Windungszahl $N_1$ und einem stirnseitigen, äußeren, d. h. von der Symmetrieebene 12 weiter entfernt liegenden bogenförmigen Leiterstück 15 mit einer Windungszahl $N_2$ ein weiteres bogenförmiges Leiterstück 16, das zu dem der Symmetrieebene 12 zugewandten bogenförmigen Leiterstück 14 elektrisch parallelgeschaltet ist und eine Windungszahl $N_3$ hat. Die Länge der bogenförmigen Leiterstücke 14 bis 16 in Umfangsrichtung wird dabei vorteilhaft so gewählt, daß sich jeweils ein zentraler Bogenwinkel $\alpha$ zwischen 90° und 150° ergibt. Vorzugsweise sollen die bogenförmigen Leiterstücke jeweils einem Winkel von 121° bis 134° entsprechen.

Die bogenförmigen Leiterstücke 14 bis 16, die über gerade, in z-Richtung verlaufende Leiterstücke 17 und 18 bzw. 17' und 18' zu der jeweiligen sattelförmigen Spule zusammengesetzt sind, haben vorbestimmte Abstände von der Symmetrieebene 12. Außerdem wird für die bezüglich der Symmetrieebene 12 weiter entfernt liegenden bogenförmigen Leiterstücke 15 eine wesentlich größere Amperewindungszahl als für die der Symmetrieebene zugewandten bogenförmigen Leiterstücke 14 gewählt. Unter der Amperewindungszahl, auch Strombelag oder elektrische Durchflutung genannt, wird dabei das Produkt aus dem Betrag der Stromstärke I und der jeweiligen Windungszahl N eines Spulenteiles verstanden. Die Größe der Amperewindungszahl in dem zwischen den beiden stirnseitigen bogenförmigen Leiterstücken 14 und 15 liegenden Leiterstück 16 soll zwischen den Größen der Durchflutungen in diesen stirnseitigen Leiterstücken liegen. Die elektrischen Amperewindungszahlen $I \cdot N_1$, $I \cdot N_3$ und $I \cdot N_2$ der bogenförmigen Leiterstücke 14, 16 und 15 haben demnach mit zunehmendem Abstand von der Symmetrieebene 12 vergrößerte Werte.

Der von der Symmetrieebene 12 gemessene Abstand $a_1$ der der Symmetrieebene zugewandten bogenförmigen Leiterstücke 14 hat vorteilhaft einen Wert zwischen $0,1 \cdot r$ und $0,4 \cdot r$. Vorzugsweise wird ein Wert von etwa $0,24 \cdot r$ gewählt. Der Abstand $a_2$ der äußeren bogenförmigen Leiterstücke 15 von der Symmetrieebene 12 ist von dem Abstand $a_1$ abhängig und liegt vorteilhaft zwischen $2,5 \cdot a_1$ und $100 \cdot a_1$. Vorzugsweise wird für den Abstand $a_2$ ein Wert von etwa $7 \cdot a_1$ und insbesondere von $1,71 \cdot r$ gewählt. Der Abstand $a_3$ des mittleren bogenförmigen Leiterstückes 16, das stets zwischen dem äußeren Leiterstück 15 und dem der Symmetrieebene 12 zugewandten Leiterstück 14 liegen soll, ist von den Abständen $a_1$ und $a_2$ dieser Leiterstücke 14 und 15 abhängig. Vorteilhaft wird für den Abstand $a_3$ ein Wert vorgesehen, der zwischen $1,25 \cdot a_1$ und $0,75 \cdot a_2$ liegt. Vorzugsweise hat der Abstand $a_3$ einen Wert von etwa $1/2 \cdot (a_1 + a_2)$.

Wie in Fig. 1 ferner durch die unterschiedliche Strichstärke der bogenförmigen Leiterstücke 14 bis 16 angedeutet ist, werden für diese Leiterstücke Amperewindungszahlen vorgesehen, die in den äußeren bogenförmigen Leiterstücken 15 und den mittleren bogenförmigen Leiterstücken 16 wesentlich größer sind als in den der Symmetrieebene 12 zugewandten bogenförmigen Leiterstücken 14. Vorteilhaft wird für die äußeren bogenförmigen Leiterstücke 15 ein Betrag der Amperewindungszahl $I \cdot N_2$ gewählt, der zwei- bis fünfmal größer, vorzugsweise etwa 3,25 mal größer als der Betrag der Amperewindungszahl $I \cdot N_1$ in den der Symmetrieebene 12 zugewandten bogenförmigen Leiterstücken 14 ist. Der Betrag der Amperewindungszahl $I \cdot N_3$ in den mittleren bogenförmigen Leiterstücken 16 soll zwischen $1,1 \cdot I \cdot N_1$ und $4,5 \cdot I \cdot N_1$ betragen, wobei dieser Wert immer kleiner als der Wert für die Amperewindungszahl $I \cdot N_2$ gewählt wird. Vorzugsweise wird für die Amperewindungszahl in dem mittleren bogenförmigen Leiterstück 16 ein Wert von dem Betrag $2,25 \cdot I \cdot N_1$ vorgesehen.

Da die mittleren bogenförmigen Leiterstücke zu den jeweils zugeordneten, der Symmetrieebene zugewandten Leiterstücken 14 elektrisch parallelgeschaltet sein sollen, fließt der Strom I in diesen Leiterstücken jeweils in der gleichen Richtung. Demgegenüber ist die Flußrichtung des mit einem umgekehrten Vorzeichen gekennzeichneten Stromes in dem zugeordneten äußeren bogenförmigen Leiterstück 14 entgegengesetzt.

Wie außerdem in der Figur 1 durch Pfeile an den einzelnen bogenförmigen Leiterstücken angedeutet ist, sollen die Einzelspulen 4 bis 7 von Strömen derart durchflossen werden, daß sich in den einander benachbarten Leiterstücken 17 oder 18 bzw. 17′ oder 18′ aus jeweils zwei Einzelspulen 4, 5 oder 6, 7 jedes Spulenpaares 2 bzw. 3 gleiche Stromflußrichtungen ergeben. Außerdem sollen in diesen geraden Leiterstücken 17, 18 in dem einen Spulenpaar 2 die Stromflußrichtungen entgegengesetzt zu den Stromflußrichtungen in den entsprechenden Leiterstücken 17′, 18′ des anderen Spulenpaares 3 sein. D. h., in den beiden Einzelspulen 4, 6 bzw. 5, 7, die jeweils zueinander symmetrisch bezüglich der Symmetrieebene 12 angeordnet sind, sollen die Stromflußrichtungen ebenfalls bezüglich dieser Symmetrieebene symmetrisch verlaufen.

Bei dieser Wahl der Flußrichtungen und bei Zugrundelegung der speziellen Werte für die Abstände $a_1$ bis $a_3$ sowie für die Amperewindungszahlen $I \cdot N_1$ bis $I \cdot N_3$ wird dann vorteilhaft ein Abbildungsbereich 10 erhalten, der in einem annähernd kugelförmigen Volumen mit einem Radius der Größe von etwa $2/3 \cdot r$ weitgehend konstante Feldgradienten $G_x$ bzw. $G_y$ aufweist. Dabei ist es unerheblich, ob, wie gemäß dem Ausführungsbeispiel nach Fig. 1 angenommen ist, der Betrag des Stromes durch die bogenförmigen Leiterstücke gleich ist und nur deren Windungszahlen verschieden sind, oder ob auch verschiedene Stromstärken vorgesehen werden, um die genannten Werte der Amperewindungszahlen in diesen bogenförmigen Leiterstücken zu erhalten.

Bei den in Fig. 1 nicht gezeigten Gradientenspulen zur Erzeugung hinreichend linearer Feldgradienten $G_z$ in z-Richtung kann es sich um entsprechende Spulen bekannter Einrichtungen der Kernresonanz-Technik wie z. B. gemäß der US-A-3 569 823 oder der DE-A-2 840 178 oder der veröffentlichten europäischen Patentanmeldung EP-A-2 153 5A1 handeln. Vorteilhaft wird jedoch das Gradientenspulen-System einer bildgebenden Einrichtung der Kernspinresonanz-Technik mit den erfindungsgemäß ausgebildeten Gradientenspulen zur Erzeugung hinreichend linearer Feldgradienten in x- bzw. y-Richtung mit besonderen z-Gradientenspulen ausgestattet, die in Fig. 2 in Schrägansicht schematisch angedeutet sind. Dieses z-Gradientenspulen-System umfaßt zwei Paare 20 und 21 mit je zwei ringförmigen Einzelspulen 22 und 23 bzw. 24 und 25. Diese Einzelspulen sind auf der Innen- oder Außenmantelfläche des hohlzylindrischen Trägerkörpers 9 angeordnet, der für das Spulensystem nach der Erfindung gemäß Fig. 1 vorgesehen ist und der einen Durchmesser der Größe $2 \cdot r$ hat. Weitere, mit Fig. 1 übereinstimmende Teile sind in Fig. 2 mit den gleichen Bezugszeichen versehen.

Die beiden Spulenpaare 20 und 21 sind bezüglich der durch das Zentrum des Abbildungsbereiches 10 verlaufenden x-y-Ebene 12 symmetrisch angeordnet. Wie durch Pfeile an den ringförmigen Einzelspulen angedeutet ist, soll die Flußrichtung des Stromes I′ in den Einzelspulen 22 und 23 des Spulenpaares 20 entgegengesetzt sein zu der Flußrichtung des Stromes-I′ in den Spulen 24 und 25 des anderen Spulenpaares 21.

Um eine ausreichende Linearität der z-Gradientenfelder zu gewährleisten, werden die Einzelspulen 22 bis 25 in vorbestimmten Abständen von der Symmetrieebene durch das Koordinatensystem angeordnet. Außerdem wird für die bezüglich der Symmetrieebene 12 weiter entfernt liegenden Einzelspulen 23 und 25 eine wesentlich größere Amperewindungszahl als für die der Symmetrieebene zugewandten Einzelspulen 22 und 24 gewählt. Der Abstand $a_4$ der äußeren Einzelspulen 23 und 25 von der Symmetrieebene 12 hat vorteilhaft einen Wert zwischen $0,9 \cdot r$ und $1,3 \cdot r$. Vorzugsweise wird ein Wert von $1,1 \cdot r$ gewählt. Der Abstand $a_5$ der der Symmetrieebene 12 zugewandten Einzelspulen 22 und 24 ist von dem Abstand $a_4$ abhängig und liegt vorteilhaft zwischen $1/4 \cdot a_4$ und $1/2 \cdot a_4$. Vorzugsweise wird für ihn ein Wert von etwa $1/3 \cdot a_4$ gewählt. Bei einer Stromstärke mit einem Betrag I′ durch die einzelnen Windungen $N_4$ und $N_5$ der Spulen 23 und 25 bzw. 22 und 24 ist bei den genannten Abständen $a_4$ und $a_5$ der Einzelspulen 22 bis 25 von der Symmetrieebene 12 vorteilhaft ein Verhältnis der Amperewindungszahl $I′ \cdot N_4$ der äußeren Einzelspulen 23 bzw. 25 zu der Amperewindungszahl $I′ \cdot N_5$ der der Symmetrieebene 12 näherliegenden Einzelspulen 22 bzw. 24 zwischen 6 : 1 und 12 : 1 zu wählen. Besonders vorteilhaft ist ein Verhältnis von etwa 9 : 1.

Für die genannten Werte der Abstände $a_4$ und $a_5$ sowie der Amperewindungszahlen $I′ \cdot N_4$ und $I′ \cdot N_5$ kann dann ein Abbildungsbereich 10 mit weitgehend konstanten Feldgradienten $G_z$ erreicht werden, der etwa kugelförmige Gestalt mit einem Radius von etwa $2/3 \cdot r$ hat.

Gemäß dem Ausführungsbeispiel nach Fig. 2 wurde angenommen, daß der Betrag des Stromes durch die vier Einzelspulen 22 bis 25 gleich ist und nur die Windungszahlen $N_4$ und $N_5$ verschieden sind. Es ist jedoch ebenso möglich, auch die Ströme in den Spulen 22 und 24 bzw. 23 und 25 unterschiedlich einzustellen, um die vorbestimmten Werte für die Amperewindungszahl durch diese Spulen zu erhalten.

## Patentansprüche

1. Gradientenspulen-System für eine Einrichtung zur Erzeugung von Abbildungen eines Objekts mit Hilfe der Kernspinresonanztechnik, insbesondere für die Zeugmatographie, mit

einem den Radius r aufweisenden hohlzylindrischen Trägerkörper (9), der einen Abbildungsbereich (10) umschließt und dessen die z-Achse eines rechtwinkligen Koordinatensystems definierende Zylinderachse der Richtung des Grundmagnetfeldes $B_z$ der Einrichtung entspricht,

mindestens einem Paar von ringförmigen Einzelspulen (23, 25), die zur Erzeugung eines im Abbildungsbereich (10) im wesentlichen konstanten Magnetfeldgradienten $G_z = \partial B_z/\partial z$ entlang der z-Achse auf dem Trägerkörper (9) symmetrisch bezüglich einer durch den Abbildungsbereich (10) senkrecht zur z-Achse verlaufenden und die x-y-Ebene des Koordinatensystems bildenden Querschnittsebene angeordnet und gegensinnig stromdurchflossen sind,

einem ersten der Erzeugung eines im Abbildungsbereich (10) im wesentlichen konstanten Magnetfeldgradienten $G_x = \partial B_z/\partial x$ des Grundmagnetfeldes $B_z$ in x-Richtung dienenden Satz von sattelförmigen Einzelspulen, die sich paarweise gegenüberliegend auf die Mantelfläche des Trägerkörpers (9) aufgesetzt und außerdem paarweise symmetrisch bezüglich der genannten Querschnittsebene angeordnet sind und jeweils zwei in z-Richtung verlaufende gerade Leiterstücke (17, 18 ; 17', 18') sowie jeweils zwei senkrecht zur z-Achse in Umfangsrichtung des Trägerkörpers (9) verlaufende bogenförmige Leiterstücke (14, 15) aufweisen, wobei die Stromrichtung in den in Umfangsrichtung benachbarten geraden Leiterstücken von sich paarweise gegenüberliegenden sattelförmigen Einzelspulen jeweils gleich und ferner jeweils entgegengesetzt zu der Stromrichtung in den beiden entsprechenden geraden Leiterstücken der jeweils zu diesen Einzelspulen symmetrischen Einzelspulen ist, sowie

einem dem ersten Satz entsprechenden zweiten Satz von sattelförmigen Einzelspulen zur Erzeugung eines im Abbildungsbereich (10) im wesentlichen konstanten Magnetfeldgradienten $G_y = \partial B_z/\partial y$ des Grundmagnetfeldes $B_z$ in y-Richtung, dadurch gekennzeichnet,

a) daß den der genannten Querschnittsebene unmittelbar benachbarten bogenförmigen Leiterstücken (14) der sattelförmigen Einzelspulen (4 bis 7) zur Erzeugung der x- bzw. y-Feldgradienten $G_x$ bzw. $G_y$ jeweils ein weiteres bogenförmiges Leiterstück (16) parallelgeschaltet ist,

b) daß die Abstände der einzelnen bogenförmigen Leiterstücke (14, 16, 15) dieser Einzelspulen (4 bis 7) von der Querschnittsebene vorbestimmte Werte $a_1$ bzw. $a_3$ bzw. $a_2$ haben, und

c) daß die Amperewindungszahlen dieser bogenförmigen Leiterstücke (14, 16, 15) vorbestimmte, mit zunehmenden Abstand von der Querschnittsebene wachsende Werte haben.

2. Gradientenspulen-System nach Anspruch 1, dadurch gekennzeichnet, daß der Abstand $a_1$ zwischen der Querschnittsebene und den der Querschnittsebene unmittelbar benachbarten bogenförmigen Leiterstücken (14) der sattelförmigen Einzelspulen (4 bis 7) zwischen $0,1 \cdot r$ und $0,4 \cdot r$ liegt.

3. Gradientenspulen-System nach Anspruch 2, gekennzeichnet durch einen Abstand $a_1$ von etwa der Größe $0,24 \cdot r$.

4. Gradientenspulen-System nach einem der Ansprüche 1 bis 3, dadurch gekennzeichnet, daß der Abstand $a_2$ zwischen der Querschnittsebene und den von der Querschnittsebene weiter entfernt liegenden bogenförmigen Leiterstücken (15) der sattelförmigen Einzelspulen (4 bis 7) zwischen dem 2,5-Fachen und dem 100-Fachen des entsprechenden Abstandes $a_1$ beträgt.

5. Gradientenspulen-System nach Anspruch 4, gekennzeichnnet durch einen Abstand $a_2$ von etwa dem 7-Fachen des Abstandes $a_1$.

6. Gradientenspulen-System nach Anspruch 4 oder 5, gekennzeichnet durch einen Abstand $a_2$ von etwa der Größe $1,71 \cdot r$.

7. Gradientenspulen-System nach einem der Ansprüche 1 bis 6, dadurch gekennzeichnet, daß der Abstand $a_3$ der weiteren bogenförmigen Leiterstücke (16) zwischen $1,25 \cdot a_1$ und $0,75 \cdot a_2$ liegt.

8. Gradientenspulen-System nach Anspruch 7, gekennzeichnet durch einen Abstand $a_3$ von etwa $(a_1 + a_2)/2$.

9. Gradientenspulen-System nach einem der Ansprüche 1 bis 8, dadurch gekennzeichnet, daß die Amperewindungszahl $I \cdot N_2$ der von der Querschnittsebene weiter entfernt liegenden bogenförmigen Leiterstücke (15) der sattelförmigen Einzelspulen (4 bis 7) zwischen dem 2-Fachen und dem 5-Fachen der Amperewindungszahl $I \cdot N_1$ der der Querschnittsebene unmittelbar benachbarten bogenförmigen Leiterstücke (14) beträgt.

10. Gradientenspulen-System nach Anspruch 9, gekennzeichnet durch eine Amperewindungszahl $I \cdot N_2$, die etwa 3,25 mal größer ist als die Amperewindungszahl $I \cdot N_1$.

11. Gradientenspulen-System nach einem der Ansprüche 1 bis 10, dadurch gekennzeichnet, daß die Amperewindungszahl $I \cdot N_3$ der weiteren bogenförmigen Leiterstücke (16) zwischen dem 1,1-Fachen und 4,5-Fachen der Amperewindungszahl $I \cdot N_1$ beträgt und stets kleiner ist als die Amperewindungszahl $I \cdot N_2$.

12. Gradientenspulen-System nach Anspruch 11, gekennzeichnet durch eine Amperewindungszahl $I \cdot N_3$ von etwa dem 2,25-Fachen der Amperewindungszahl $I \cdot N_1$.

13. Gradientenspulen-System nach einem der Ansprüche 9 bis 11, dadurch gekennzeichnet, daß der Betrag des Stromes (I) durch mindestens eine der Windungen ($N_1$ bis $N_3$) der bogenförmigen Leiterstücke (14 bis 16) der Einzelspulen (4 bis 7) verschieden groß im Vergleich zu den Beträgen der Ströme durch die übrigen Windungen ist.

14. Gradientenspulen-System nach einem der Ansprüche 1 bis 13, dadurch gekennzeichnet,

a) daß zur Erzeugung der Feldgradienten $G_z$ in z-Richtung je ein zumindest annähernd symmetrisch bzgl. der Querschnittsebene angeordnetes Paar (20, 21) von zwei ringförmigen Einzelspulen (22, 23 bzw. 24, 25) vorgesehen sind, wobei die Stromflußrichtung in den ringförmigen Einzelspulen (22, 23) des einen Paares (20) entgegengesetzt zur Stromflußrichtung in den ringförmigen Einzelspulen (24, 25) des anderen Paares (21) ist,

b) daß die Abstände ($a_4$, $a_5$) der ringförmigen Einzelspulen (22 bis 25) dieser beiden Spulenpaare (20, 21) von der Querschnittsebene vorbestimmte Werte haben und

c) daß die Amperewindungszahl $I' \cdot N_4$ der bzgl. der Querschnittsebene weiter entfernt liegenden ringförmigen Einzelspulen (23, 25) dieser Spulenpaare (20, 21) wesentlich größer ist als die Amperewindungszahl $I' \cdot N_5$ der zugehörigen, näher liegenden ringförmigen Einzelspulen (22, 24).

15. Gradientenspulen-System nach Anspruch 14, dadurch gekennzeichnet, daß der Abstand $a_4$ der beiden von der Querschnittsebene weiter entfernt liegenden ringförmigen Einzelspulen (23, 25) zwischen $0.9 \cdot r$ und $1.3 \cdot r$ liegt.

16. Gradientenspulen-System nach Anspruch 15, gekennzeichnet durch einen Abstand $a_4$ von etwa $1.1 \cdot r$.

17. Gradientenspulen-System nach einem der Ansprüche 14 bis 16, dadurch gekennzeichnet, daß der Abstand $a_5$ der der Querschnittsebene näher liegenden ringförmigen Einzelspulen (22, 24) zwischen 1/4 und 1/2 des entsprechenden Abstandes $a_4$ beträgt.

18. Gradientenspulen-System nach Anspruch 17, gekennzeichnet durch einen Abstand $a_5$ von etwa 1/3 des Abstandes $a_4$.

19. Gradientenspulen-Spulen nach einem der Ansprüche 14 bis 18, dadurch gekennzeichnet, daß die Amperewindungszahl $I' \cdot N_4$ zwischen dem 6-Fachen und dem 12-Fachen der Amperewindungszahl $I' \cdot N_5$ beträgt.

20. Gradientenspulen-System nach Anspruch 19, gekennzeichnet durch eine Amperewindungszahl $I' \cdot N_4$, die etwa 9 mal größer ist als die Amperewindungszahl $I' \cdot N_5$.

21. Gradientenspulen-System nach einem der Ansprüche 1 bis 13, dadurch gekennzeichnet, daß der zentrale Bogen- bzw. Öffnungswinkel ($\alpha$) der bogenförmigen Leiterstücke (14 bis 16) der sattelförmigen Einzelspulen (4 bis 7) zwischen 90° und 150° liegt.

22. Gradientenspulen-System nach Anspruch 21, gekennzeichnet durch einen zentralen Bogen- bzw. Öffnungswinkel ($\alpha$) der bogenförmigen Leiterstücke (14 bis 16) zwischen 121° und 134°.

## Claims

1. A gradient coil system for a device for producing images of an object with the aid of nuclear magnetic-resonance technology, in particular for zeugmatography, comprising :

a hollow-cylindrical carrier body (9) having a radius r surrounding an imaging region (10) and whose longitudinal axis, which defines the z axis of a rectangular coordinate system, corresponds to the direction of the basic magnetic field $B_z$ of the device ;

at least one pair of individual annular coils (23, 24) arranged along the z axis on the carrier body (9) so as to be symmetrical in respect of a cross-sectional plane which extends through the imaging region (10) at right angles to the z axis and forms the x-y plane of the coordinate system, and traversed by opposing current for the production of a magnetic field gradient $G_z = \partial B_z/\partial z$, which is essentially constant in the imaging region (10) ;

a first set of individual saddle-shaped coils for the production of a magnetic field gradient $G_x = \partial B_z/\partial x$ of the basic magnetic field $B_z$ in the x direction and essentially constant in the imaging region (10), placed on the surface of the carrier body (9) in mutually opposite pairs that are symmetrically arranged in pairs with respect to the plane of said cross-section, the respective saddle-shaped coils having two straight conductor sections (17, 18 ; 17', 18') which extend in the z direction and two curved conductor sections (14, 15) which extend at right angles to the z axis in the circumferential direction of the carrier body (9), where the current direction in the straight conductor sections of mutually opposed individual saddle-shaped coils mutually adjacent in the circumferential direction is identical and opposite to the current direction in the corresponding two straight conductor sections of the individual coils respectively symmetrical to those individual coils ; and

a second set of individual saddle-shaped coils corresponding to the first set to produce a magnetic field gradient $G_y = \partial B_z/\partial y$ of the basic magnetic field $B_z$ in the y direction which is essentially constant in the imaging region (10) ; characterised in

a) that a further curved conductor section (16) is respectively connected in parallel to the curved conductor sections (14) directly adjacent to said cross-sectional plane of the individual saddle-shaped coils (4 to 7) in order to produce the x and y field gradients $G_x$ and $G_y$ ;

b) that the distances of the individual curved conductor sections (14, 16, 15) of the individual coils (4 to 7) from the cross-sectional plane have predetermined values $a_1$ and $a_3$ and $a_2$ ; and

c) that the numbers of ampere-turns of these curved conductor sections (14, 16, 15) have predetermined values which increase with increasing distance from the cross-sectional plane.

2. A gradient coil system as claimed in Claim 1, characterised in that the distance $a_1$ between the cross-sectional plane and the curved conductor sections (14) of the individual saddle-shaped coils (4 to 7) directly adjacent to the cross-sectional plane ranges between 0.1 and 0.4 times the value of r.

3. A gradient coil system as claimed in Claim 2, characterised by a distance $a_1$ of approximately 0.24 times the value of r.

4. A gradient coil system as claimed in one of Claims 1 to 3, characterised in that the distance $a_2$ between the cross-sectional plane and the curved conductor sections (15) of the individual saddle-shaped coils (4 to 7) which are arranged so as to be further removed from the cross-sectional plane ranges between 2.5 and 100 times the corresponding distance $a_1$.

5. A gradient coil system as claimed in Claim 4, characterised by a distance $a_2$ of approximately 7 times the distance $a_1$.

6. A gradient coil system as claimed in Claim 4 or 5, characterised by a distance $a_2$ of approximately 1.71 times the value of r.

7. A gradient coil system as claimed in one of Claims 1 to 6, characterised in that the distance $a_3$ of the further curved conductor sections (16) ranges between 1.25 times $a_1$ and 0.75 times $a_2$.

8. A gradient coil system as claimed in Claim 7, characterised by a distance $a_3$ of approximately $(a_1 + a_2)/2$.

9. A gradient coil system as claimed in one of Claims 1 to 8, characterised in that the number of ampere-turns $I \cdot N_2$ of the curved conductor sections (15) of the individual saddle-shaped coils (4 to 7) which are arranged so as to be further removed from the cross-sectional plane amounts to from twice to five times the number of ampere-turns $I \cdot N_1$ of the curved conductor sections (14) which are directly adjacent to the cross-sectional plane.

10. A gradient coil system as claimed in Claim 9, characterised by a number of ampere-turns $I \cdot N_2$ which is approximately 3.25 times greater than the number of ampere-turns $I \cdot N_1$.

11. A gradient coil system as claimed in one of Claims 1 to 10, characterised in that the number of ampere-turns $I \cdot N_3$ of the further curved conductor sections (16) lies between approximately 1.1 and 4.5 times the number of ampere-turns $I \cdot N_1$ and is constantly smaller than the number of ampere-turns $I \cdot N_2$.

12. A gradient coil system as claimed in Claim 11, characterised by a number of ampere-turns $I \cdot N_3$ of approximately 2.25 times the number of ampere-turns $I. \cdot N_1$.

13. A gradient coil system as claimed in one of Claims 9 to 11, characterised in that the amount of the current (I) through at least one of the turns ($N_1$ to $N_3$) of the curved conductor sections (14 to 16) of the individual coils (4 to 7) is different to the amounts of the currents through the remaining turns.

14. A gradient coil system as claimed in one of Claims 1 to 13, characterised in

a) that in order to produce the field gradient $G_z$ in the z direction a pair (20, 21) of two annular individual coils (22, 23 and 24, 25) is respectively provided arranged to be at least approximately symmetrical in relation to the cross-section plane, where the direction of current flow in the individual annular coils (22, 23) of the one pair (20) is opposed to the direction of current flow in the individual annular coils (24, 25) of the other pair (21) ;

b) that the distances ($a_4$, $a_5$) of the individual annular coils (22 to 25) of these two coils pairs (20, 21) from the cross-section plane have predetermined values ; and

c) that the number of ampere-turns $I' \cdot N_4$ of the individual annular coils (23, 25) of the coil pairs (20, 21) arranged to be further removed from the cross-section plane is substantially greater than the number of ampere-turns $I' \cdot N_5$ of the assigned, more closely arranged individual annular coils (22, 24).

15. A gradient coil system as claimed in Claim 14, characterised in that the distance $a_4$ of the two individual annular coils (23, 25) arranged further removed from the cross-section plane ranges between 0.9 and 1.3 times the value of r.

16. A gradient coil system as claimed in Claim 15, characterised by a distance $a_4$ of approximately 1.1 times the value of r.

17. A gradient coil system as claimed in one of Claims 14 to 16, characterised in that the distance $a_5$ of the individual annular coils (22, 24) more closely arranged to the cross-section plane ranges between 1/4 and 1/2 of the corresponding distance $a_4$.

18. A gradient coil system as claimed in Claim 17, characterised by a distance $a_5$ of approximately 1/3 of the distance $a_4$.

19. A gradient coil system as claimed in one of Claims 14 to 18, characterised in that the number of ampere-turns $I' \cdot N_4$ ranges between 6 and 12 times the number of ampere-turns $I' \cdot N_5$.

20. A gradient coil system as claimed in Claim 19, characterised by a number of ampere-turns $I' \cdot N_4$ approximately 9 times greater than the number of ampere-turns $I' \cdot N_5$.

21. A gradient coil system as claimed in one of Claims 1 to 13, characterised in that the central curved or apertural angle ($\alpha$) of the curved conductor sections (14 to 16) of the individual saddle-shaped coils (4 to 7) ranges between 90° and 150°.

22. A gradient coil system as claimed in Claim 21, characterised by a central curved or apertural angle ($\alpha$) of the curved conductor sections (14 to 16) of between 121° and 134°.

**Revendications**

1. Système de bobines à gradients pour un dispositif servant à produire des images d'un objet à l'aide de la technique de la résonance magnétique nucléaire, notamment pour la zeugmatographie, comportant :

un corps de support (9) en forme de cylindre creux possédant le rayon r et qui entoure une zone (10) de formation d'images et dont l'axe, qui définit l'axe z d'un système de coordonnées rectangulaires, correspond à la direction du champ magnétique principal $B_z$ du dispositif,

au moins une paire de bobines individuelles annulaires (23, 25) qui, en vue de la production d'un gradient de champ magnétique $G_z = \partial B_z/\partial z$, essentiellement constant dans la zone de formation d'images (10) suivant la direction z, sont disposées sur le corps de support (9) symétriquement par rapport à un plan de coupe transversale traversant la zone de formation d'images (10) en étant perpendiculaire à l'axe z et constituant le plan x-y du système de coordonnées, et sont parcourues dans le sens opposé par le courant,

un premier ensemble de bobines individuelles en forme de selles utilisées pour la production d'un gradient de champ magnétique $G_x = \partial B_z/\partial x$ du champ magnétique principal $B_z$, essentiellement constant dans la zone de formation d'images (10), suivant la direction x et qui sont montées en vis-à-vis par paires sur la surface enveloppe du corps de support (9) et sont en outre disposées par paires symétriquement par rapport audit plan de coupe transversal et possèdent chacune deux éléments conducteurs rectilignes (17, 18 ; 17', 18') s'étendant suivant la direction z, ainsi que respectivement deux éléments conducteurs (14, 15) en forme d'arcs de cercle s'étendant perpendiculairement à l'axe z suivant la direction circonférentielle du corps de support (9), le sens du courant dans les éléments conducteurs rectilignes, voisins suivant la direction circonférentielle, de bobines individuelles en forme de selles situées en vis-à-vis par paires étant le même et étant en outre respectivement opposé au sens du courant dans les deux éléments conducteurs rectilignes correspondants des bobines individuelles respectivement symétriques de ces bobines individuelles, ainsi que

un second ensemble de bobines individuelles en forme de selles, correspondant au premier ensemble pour la production d'un gradient de champ magnétique $G_y = \partial B_z/\partial y$ du champ magnétique principal $B_z$, essentiellement constant dans la zone de formation d'images (10), suivant la direction y, caractérisé par le fait que

a) respectivement un autre élément conducteur en forme d'arc de cercle (16) est branché en parallèle avec les éléments conducteurs en forme d'arcs de cercle (14), qui sont directement voisins dudit plan de coupe transversal, des bobines individuelles en forme de selles (4 à 7) en vue de réaliser la production des gradients de champ $G_x$ et $G_y$ suivant x et y,

b) que les distances entre les éléments conducteurs individuels en forme d'arcs de cercle (14, 16, 15) de ces bobines individuelles (4 à 7) possèdent des valeurs $a_1$, $a_3$ ou $a_2$, prédéterminées par le plan de coupe transversal, et

c) que les nombres d'ampères-tours de ces éléments conducteurs en forme d'arcs de cercle (14, 16, 15) possèdent des valeurs prédéterminées qui augmentent lorsque la distance par rapport au plan de coupe transversal augmente.

2. Système de bobines à gradients suivant la revendication 1, caractérisé par le fait que la distance $a_1$ entre le plan de coupe transversale et les éléments conducteurs en forme d'arcs de cercle (14), qui sont directement voisins du plan de coupe transversal, des bobines individuelles en forme de selles (4 à 7), est comprise entre $0,1 \cdot r$ et $0,4 \cdot r$.

3. Système de bobines à gradients suivant la revendication 2, caractérisé par une distance $a_1$ ayant approximativement pour valeur $0,24 \cdot r$.

4. Système de bobines à gradients suivant l'une des revendications 1 à 3, caractérisé par le fait que la distance $a_2$ entre le plan de coupe transversal et les éléments conducteurs en forme d'arcs de cercle (15), qui sont plus éloignés du plan de coupe transversal, des bobines individuelles en forme de selles (4 à 7), est comprise entre 2,5 fois et 100 fois la distance corrrespondante $a_1$.

5. Système de bobines à gradients suivant la revendication 4, caractérisé par une distance $a_2$ égale approximativement au septuple de la distance $a_1$.

6. Système de bobines à gradients suivant la revendication 4 ou 5, caractérisé par une distance $a_2$ égale approximativement à la valeur de $1,71 \cdot r$.

7. Système de bobines à gradients suivant l'une des revendications 1 à 6, caractérisé par le fait que la distance $a_3$ des autres éléments conducteurs en forme d'arcs de cercle (16) se situe entre $1,25 \cdot a_1$ et $0,75 \cdot a_2$.

8. Système de bobines à gradients suivant la revendication 7, caractérisé par une distance $a_3$ égale à environ $(a_1 + a_2)/2$.

9. Système de bobines à gradients suivant l'une des revendications 1 à 8, caractérisé par le fait que le nombre d'ampères-tours $I \cdot N_2$ des éléments conducteurs en forme d'arcs de cercle (15), qui sont plus éloignés du plan de coupe transversal, des bobines individuelles en forme de selles (4 à 7) est compris entre le double et le quintuple du nombre d'ampères-tours $I \cdot N_1$ des éléments conducteurs en forme d'arcs de cercle (14), qui sont directement voisins du plan de coupe transversale.

10. Système de bobines à gradients suivant la revendication 9, caractérisé par un nombre d'ampères-tours $I \cdot N_2$ qui est environ 3,25 fois supérieur au nombre d'ampères-tours $I \cdot N_1$.

11. Système de bobines à gradients suivant l'une des revendications 1 à 10, caractérisé par le fait que le nombre d'ampères-tours $I \cdot N_3$ des autres éléments conducteurs en forme d'arcs de cercle (16) est comprise entre 1,1 fois et 4,5 fois le nombre d'ampères-tours $I \cdot N_1$ et est toujours inférieur au nombre d'ampères-tours $I \cdot N_2$.

12. Système de bobines à gradients suivant la revendication 11, caractérisé par un nombre d'ampères-tours $I \cdot N_3$ égal à environ 2,25 fois le nombre d'ampères-tours $I \cdot N_1$.

13. Système de bobines à gradients suivant l'une des revendications 9 à 11, caractérisé par le fait que la valeur du courant (I) circulant dans au moins l'une des spires ($N_1$ à $N_3$) des éléments conducteurs en forme d'arcs de cercle (14 à 16) des bobines individuelles (4 à 7) est différente des valeurs des courants traversant les autres spires.

14. Système de bobines à gradients suivant l'une des revendications 1 à 13, caractérisé par le fait que

a) pour la production du gradient de champ $G_z$ suivant la direction z, il est prévu respectivement une paire (20, 21) de deux bobines individuelles annulaires (22, 23 ou 24, 25), qui sont disposées au moins approximativement symétriquement par rapport au plan de coupe transversale, le sens du courant dans les bobines individuelles annulaires (22, 23) d'un couple (20) étant opposé au sens du courant dans les bobines individuelles annulaires (24, 25) de l'autre couple (21),

b) que les distances ($a_4$, $a_5$) des bobines individuelles annulaires (22 à 25) de ces deux paires de bobines (20, 21) par rapport au plan de coupe transversale, ont des valeurs prédéterminées, et

c) que le nombre d'ampères-tours $I' \cdot N_4$ des bobines individuelles annulaires (23, 25) de ces paires de bobines (20, 21), qui sont plus éloignées du plan de coupe transversal, est nettement supérieur au nombre d'ampères-tours $I' \cdot N_5$ des bobines individuelles annulaires associées (22, 24) qui sont plus rapprochées.

15. Système à gradients selon la revendication 14, caractérisé par le fait que la distance $a_4$ des deux bobines individuelles annulaires (23, 25), qui sont plus éloignées du plan de coupe transversal, est comprise entre $0,9 \cdot r$ et $1,3 \cdot r$.

16. Système de bobines à gradients suivant la revendication 15, caractérisé par une distance $a_4$ égale à environ $1,1 \cdot r$.

17. Système de bobines à gradients suivant l'une des revendications 14 à 16, caractérisé par le fait que la distance $a_5$ des bobines individuelles annulaires (22, 24), qui sont plus rapprochées du plan de coupe transversal, est comprise entre environ 1/4 et 1/2 de la distance $a_4$ correspondante.

18. Système de bobines à gradients suivant la revendication 17, caractérisé par une distance $a_5$ égale à environ 1/3 de la distance $a_4$.

19. Système de bobines à gradients suivant l'une des revendications 14 à 18, caractérisé par le fait que le nombre d'ampères-tours $I \cdot N_4$ est compris entre 6 fois et 12 fois le nombre d'ampères-tours $I' \cdot N_5$.

20. Système de bobines à gradients suivant la revendication 19, caractérisé par le nombre d'ampères-tours $I' \cdot N_4$, qui est égal à environ 9 fois le nombre d'ampères-tours $I' \cdot N_5$.

21. Système de bobines à gradients suivant l'une des revendications 1 à 13, caractérisé par le fait que l'angle au centre ou l'angle d'ouverture ($\alpha$) des éléments conducteurs en forme d'arcs de cercle (14 à 16) des bobines individuelles en forme de selles (4 à 7) est compris entre 90° et 150°.

22. Système de bobines à gradients suivant la revendication 21, caractérisé par un angle au centre ou un angle d'ouverture ($\alpha$) des éléments conducteurs en forme d'arcs de cercle (14 à 16) qui est compris entre 121° et 134°.

FIG 1

FIG 2